(19) **Europäisches Patentamt European Patent Office Office européen des brevets**

(11) **EP 4 506 068 A1**

(12) **EUROPEAN PATENT APPLICATION**
published in accordance with Art. 153(4) EPC

(43) Date of publication:
**12.02.2025 Bulletin 2025/07**

(21) Application number: **23803565.3**

(22) Date of filing: **10.05.2023**

(51) International Patent Classification (IPC):
**B05D 3/00** (2006.01)      **B05D 3/02** (2006.01)
**B05D 7/00** (2006.01)      **B32B 27/30** (2006.01)
**C08J 7/046** (2020.01)      **H10N 30/20** (2023.01)
**H10N 30/30** (2023.01)      **H10N 30/85** (2023.01)
**H10N 30/857** (2023.01)

(52) Cooperative Patent Classification (CPC):
**B05D 3/00; B05D 3/02; B05D 7/00; B32B 27/30;
C08J 7/046; H10N 30/20; H10N 30/30;
H10N 30/85; H10N 30/857**

(86) International application number:
**PCT/JP2023/017501**

(87) International publication number:
**WO 2023/219090 (16.11.2023 Gazette 2023/46)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **11.05.2022   JP 2022078219**

(71) Applicant: **Kureha Corporation
Chuo-ku
Tokyo 103-8552 (JP)**

(72) Inventors:
• **IMAJI, Makoto
  Tokyo 103-8552 (JP)**
• **MOTOMURA, Momoe
  Tokyo 103-8552 (JP)**

(74) Representative: **Hoefer & Partner Patentanwälte
mbB
Pilgersheimer Straße 20
81543 München (DE)**

(54) **MULTILAYER PIEZOELECTRIC FILM, DEVICE, AND METHOD FOR PRODUCING MULTILAYER PIEZOELECTRIC FILM**

(57)      Provided is a multilayer piezoelectric film excellent in thermal stability, adhesiveness, and transparency. The multilayer piezoelectric film includes: a piezoelectric film containing a fluorine-based resin as a main component; and a thermosetting hard coat layer laminated on at least one surface of the piezoelectric film. The multilayer piezoelectric film has an absolute value of a thermal shrinkage rate of 1.0% or less in both a machine direction (MD) and a transverse direction (TD) when heat-treated at 100°C for 30 minutes, adhesiveness between the piezoelectric film and the thermosetting hard coat layer as evaluated based on ASTM D3359 is 4B or more, and b* in the L*a*b* color system is -0.7 or more and 0.7 or less.

FIG. 1

EP 4 506 068 A1

Description

## TECHNICAL FIELD

The present invention relates to a multilayer piezoelectric film, a device including the multilayer piezoelectric film, and a method for producing the multilayer piezoelectric film.

## BACKGROUND ART

In recent years, a touch sensor has been introduced into an electronic device such as a smartphone or a tablet and is used as a human-machine interface that enables intuitive operations. The touch sensor is used to detect a two-dimensional position touched by a finger or a pen (see, for example, Patent Document 1).

Recently, a touch sensor that detects a pressing force has been developed for the purpose of increasing input information and improving operability. Examples of a method of detecting the pressing force include a method of detecting the pressing force based on a change in capacitance when the housing is distorted or a change in resistance value using a pressure-sensitive rubber, and a method of detecting a change in charge of a piezoelectric material. For a piezoelectric film of a touch panel capable of detecting a pressing force (Z coordinate), for example, a piezoelectric material containing polyvinylidene fluoride or a polyvinylidene fluoride-tetrafluoroethylene copolymer is known.

## CITATION LIST

## PATENT DOCUMENT

Patent Document 1: JP H05-324203 A

## SUMMARY OF INVENTION

## TECHNICAL PROBLEM

Such a piezoelectric film is required to have transparency in order to maintain visibility of a display located on the back side of the touch panel. In addition, in order to impart scratch resistance, a hard coat layer may be laminated on the piezoelectric film. However, when the adhesiveness between the piezoelectric film and the hard coat layer is low, there is a concern that the piezoelectric film and the hard coat layer may be peeled off from each other, and thus the piezoelectric film and the hard coat layer need to also have adhesiveness.

Further, in a sensor using a piezoelectric film, it is necessary to form an electrode at a predetermined position on the film surface with high accuracy. The formation of the electrode is often accompanied by heating, and in the case of a piezoelectric film having a high thermal shrinkage rate, thermal stability is also required so as not to cause displacement of the electrode position or defects in appearance due to thermal shrinkage in a treatment accompanied by heating.

The present invention has been made in view of the above-described issues, and an object thereof is to provide a multilayer piezoelectric film excellent in thermal stability, adhesiveness, and transparency, a device including the multilayer piezoelectric film, and a method for producing the multilayer piezoelectric film.

## SOLUTION TO PROBLEM

The present inventors have found that the above-described issues can be solved by a multilayer piezoelectric film that includes a piezoelectric film containing a fluorine-based resin as a main component, and a thermosetting hard coat layer laminated on at least one surface of the piezoelectric film, wherein a predetermined thermal shrinkage rate, adhesiveness, and b* of the multilayer piezoelectric film satisfy respective specific ranges. Thus, the inventors have completed the present invention. Specifically, the present invention relates to the following.

The present invention relates to a multilayer piezoelectric film including: a piezoelectric film containing a fluorine-based resin as a main component; and a thermosetting hard coat layer laminated on at least one surface of the piezoelectric film, wherein the multilayer piezoelectric film has an absolute value of a thermal shrinkage rate of 1.0% or less in both a machine direction (MD) and a transverse direction (TD) when heat-treated at 100°C for 30 minutes, adhesiveness between the piezoelectric film and the thermosetting hard coat layer as evaluated based on ASTM D3359 is 4B or more, and b* in an L*a*b* color system is -0.7 or more and 0.7 or less.

The multilayer piezoelectric film preferably includes an ultraviolet-curable hard coat layer on a surface of the piezoelectric film on the side opposite the thermosetting hard coat layer.

The multilayer piezoelectric film preferably has a piezoelectric constant $d_{33}$ of 10 pC/N or greater.

The multilayer piezoelectric film preferably has a total light transmittance of 90% or more.

The thermosetting hard coat layer preferably contains at least one cured material selected from the group consisting of a (meth)acrylic resin, an epoxy resin, an amino resin, and a urethane resin.

The present invention also relates to a device including the multilayer piezoelectric film.

Furthermore, the present invention relates to a method for producing the multilayer piezoelectric film, the method including: applying a thermosetting hard coating agent to at least one surface having a water contact angle of 75° or less of a piezoelectric film having an absolute value of a thermal shrinkage rate of 2.0% or more in at least either a machine direction (MD) or a transverse direction (TD); and heat-treating the applied piezoelectric film at 110°C or more and 140°C or less for 15 seconds or more and 80 minutes or less.

The above-described production method preferably includes: applying an ultraviolet-curable hard coating agent to a surface of the piezoelectric film on the side opposite the thermosetting hard coat layer; heat-treating the applied piezoelectric film at 40°C or more and 100°C or less; and irradiating the ultraviolet-curable hard coating agent-applied surface with ultraviolet rays. Corona treatment is preferable as a method for adjusting the water contact angle of the surface of the piezoelectric film to 75° or less.

**ADVANTAGEOUS EFFECTS OF INVENTION**

According to the present invention, a multilayer piezoelectric film excellent in thermal stability, adhesiveness, and transmissivity, a device including the multilayer piezoelectric film, and a method for producing the multilayer piezoelectric film can be provided.

**BRIEF DESCRIPTION OF THE DRAWINGS**

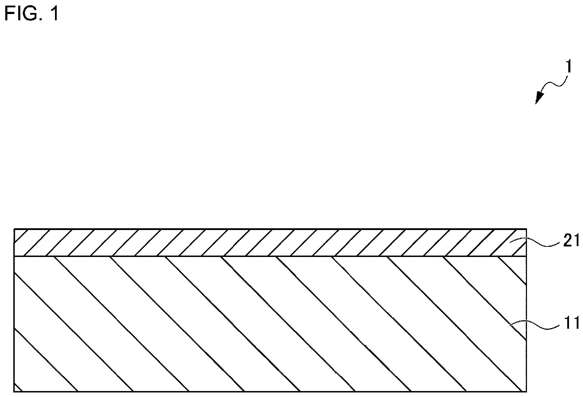

FIG. 1 is a cross-sectional view schematically illustrating a multilayer piezoelectric film 1 as an embodiment of a multilayer piezoelectric film according to the present invention.

**DESCRIPTION OF EMBODIMENTS**

Hereinafter, embodiments of the present invention (hereinafter referred to as "the present embodiment") will be described in detail with reference to the drawings, but the present invention is not limited to these embodiments, and various modifications can be made without departing from the gist of the present invention.

In the present specification, "multilayer" means that each layer is laminated in order, and another layer may be laminated between the layers.

Multilayer Piezoelectric Film

The multilayer piezoelectric film according to one embodiment of the present invention includes: a piezoelectric film containing a fluorine-based resin as a main component; and a thermosetting hard coat layer laminated on at least one surface of the piezoelectric film, wherein the multilayer piezoelectric film has an absolute value of a thermal shrinkage rate of 1.0% or less in both a machine direction (MD) and a transverse direction (TD) when heat-treated at 100°C for 30 minutes, adhesiveness between the piezoelectric film and the thermosetting hard coat layer as evaluated based on ASTM D3359 is 4B or more, and b * in an L*a*b* color system is -0.7 or more and 0.7 or less.

Properties of Multilayer Piezoelectric Film

The multilayer piezoelectric film has an absolute value of a thermal shrinkage rate of 1.0% or less in both a machine direction (MD) and a transverse direction (TD) when heat-treated at 100°C for 30 minutes, adhesiveness between the piezoelectric film and the thermosetting hard coat layer as evaluated based on ASTM D3359 is 4B or more, and b* in an L*a*b* color system is -0.7 or more and 0.7 or less.

The absolute value of the thermal shrinkage rate of the multilayer piezoelectric film is preferably 0.5% or less in both the machine direction (MD) and the transverse direction (TD) because excellent thermal stability is likely to be obtained. The lower limit thereof is not particularly limited.

In the present specification, the thermal shrinkage rate is a value measured by a method described in Examples described later.

In the present specification, the adhesiveness is evaluated by a method described in Examples described later.

The b* of the multilayer piezoelectric film is preferably -0.5 or more and 0.5 or less, and more preferably -0.3 or more and 0.3 or less because excellent transparency is likely to be obtained.

In the present specification, the b* is measured in accordance with JIS Z 8722.

The total light transmittance of the multilayer piezoelectric film is preferably 85% or more, and more preferably 90% or more, because excellent transparency is likely to be obtained. The upper limit of the total light transmittance is not particularly limited.

In the present specification, the total light transmittance is measured in accordance with JIS K 7361-1.

The haze value of the multilayer piezoelectric film is preferably 2.0% or less, more preferably 1.2% or less, and still more preferably 0.8% or less because excellent transparency is likely to be obtained. The lower limit of the haze value is not particularly limited.

In the present specification, the haze value is measured in accordance with JIS K 7136.

The thickness of the multilayer piezoelectric film is preferably 10 μm or more and 200 μm or less, more preferably 20 μm or more and 100 μm or less, and still more preferably 30 μm or more and 80 μm or less. When the thickness is 10 μm or more, the mechanical strength tends to be sufficient. Furthermore, when the thickness is 200 μm or less, the transparency tends to be sufficient, making it easy to use for optical applications.

Next, each layer of the multilayer piezoelectric film will be described with reference to drawings.

FIG. 1 is a cross-sectional view schematically illustrating a multilayer piezoelectric film 1 as one embodiment of the multilayer piezoelectric film. The multilayer piezoelectric film 1 includes a thermosetting hard coat layer 21 laminated on one surface of a piezoelectric film 11.

Piezoelectric Film

The piezoelectric film 11 is a film (thin film) with piezoelectricity (a property of converting an applied force to a voltage or a property of converting an applied voltage to a force), and contains a fluorine-based resin as a main component. By containing a fluorine-based resin as a main component, better piezoelectricity and transparency are obtained as compared with a piezoelectric film containing polylactic acid or the like as a main component. In the present specification, "containing a fluorine-based resin as a main component" means that the mass of the constituent components of the fluorine-based resin is 50 mass% or more with respect to the mass of the piezoelectric film.

The material constituting the piezoelectric film 11 is a polymer compound, and specific examples of the same include a polarized polymer compound that can develop piezoelectricity by polarizing molecular dipoles through a polarization process that is generally called a thermal poling process, or a stretched chiral polymer compound that can be made by applying a stretching process to a chiral polymer compound to exhibit piezoelectricity. Examples of the polarized polymer compound include fluorine-based resins; vinylidene cyanide polymers; vinyl acetate polymers; odd-numbered nylons such as nylon 9 and nylon 11; and polyurea. Examples of the stretched chiral polymer compound include helical chiral polymer compounds such as polylactic acid; polyhydroxycarboxylic acids such as polyhydroxybutyrate; and cellulose derivatives. One of these can be used individually, or two or more can be used in combination. The piezoelectric film 11 is a polymer compound containing a fluorine-based resin as a main component, and the polymer compound is preferably a fluorine-based resin.

Examples of the fluorine-based resin include polyvinylidene fluoride (PVDF), vinylidene fluoride-based copolymers (e.g., vinylidene fluoride/trifluoroethylene copolymers, vinylidene fluoride/trifluoroethylene/chlorotrifluoroethylene copolymers, hexafluoropropylene/vinylidene fluoride copolymers, perfluorovinyl ether/vinylidene fluoride copolymers, tetrafluoroethylene/vinylidene fluoride copolymers, hexafluoropropylene oxide/vinylidene fluoride copolymers, hexafluoropropylene oxide/tetrafluoroethylene/vinylidene fluoride copolymers, and hexafluoropropylene/tetrafluoroethylene/vinylidene fluoride copolymers); tetrafluoroethylene-based polymers; and chlorotrifluoroethylene-based polymers. One of these can be used individually, or two or more can be used in combination. Among these, in terms of high piezoelectricity, weather resistance, heat resistance, and the like to be obtained, polyvinylidene fluoride and/or a vinylidene fluoride-based copolymer is more preferred.

The piezoelectric constant $d_{33}$ of the multilayer piezoelectric film 11 is preferably 10 pC/N or more, more preferably 12 pC/N or more, and still more preferably 15 pC/N or more, because higher piezoelectricity and higher detection sensitivity are provided. In the present specification, the piezoelectric constant $d_{33}$ is a value measured by a method described in Examples described later.

The thickness of the piezoelectric film 11 is preferably 10 μm or more and 200 μm or less, more preferably 20 μm or more and 100 μm or less, and still more preferably 30 μm or more and 80 μm or less. When the thickness is 10 μm or more, the mechanical strength tends to be sufficient. Furthermore, when the thickness is 200 μm or less, the transparency tends to be sufficient, making it easy to use for optical applications.

Thermosetting Hard Coat Layer

The multilayer piezoelectric film 1 includes a thermosetting hard coat layer 21 laminated on one surface of the piezoelectric film 11.

By providing the thermosetting hard coat layer 21, it is possible to prevent scratches from occurring in the multilayer piezoelectric film 1 and to improve the transparency of the multilayer piezoelectric film 1.

The thermosetting hard coat layer is a layer of a thermosetting resin obtained by curing a thermosetting resin composition. Examples of the thermosetting resin include organic thermosetting resins such as a (meth)acrylic resin, an epoxy resin, an amino resin, and a urethane resin, as well as inorganic thermosetting resins such as silicone resins. Among these, organic thermosetting resins are preferable because the resin is easily cured at a relatively low temperature and the adhesiveness to the piezoelectric film is easily improved. It is more preferable that the thermosetting resin contains any of (meth)acrylic resins, epoxy resins, amino resins, and urethane resin, and even more preferably contains a (meth)acrylic resin.

The thermosetting resin composition may contain fine particles (organic fine particles and/or inorganic fine particles) from the viewpoints of increasing the strength of the coating film, adjusting the refractive index, increasing the transparency of the multilayer piezoelectric film, and the like. Examples of the organic fine particles include organic silicon fine particles, cross-linked acrylic fine particles, and cross-linked polystyrene fine particles. Examples of the inorganic fine particle include synthetic silica particles, talc particles, diatomaceous earth particles, calcium carbonate particles, feldspar particles, quartz particles, aluminum oxide fine particles, zirconium oxide fine particles, titanium oxide fine particles, and iron oxide fine particles. One of these can be used individually, or two or more can be used in combination.

A thermosetting hard coat layer that is too thin may not be able to sufficiently cover fine surface irregularities of the piezoelectric film, and it may be possible that the thermosetting hard coat layer fails to provide a sufficient effect of reducing the haze of the piezoelectric film. On the other hand, a thermosetting hard coat layer that is too thick does not allow an external stress to be sufficiently transmitted to the piezoelectric film, and thus the piezoelectricity of the multilayer piezoelectric film may be insufficient. Therefore, the thickness of the thermosetting hard coat layer is preferably 0.05 $\mu$m or more, more preferably 0.1 $\mu$m or more, and even more preferably 0.5 $\mu$m or more from the viewpoint of reducing the haze of the piezoelectric film. In addition, the thickness of the thermosetting hard coat layer is preferably 3.0 $\mu$m or less, more preferably 2.0 $\mu$m or less, and even more preferably 1.5 $\mu$m or less from the viewpoint of obtaining a multilayer piezoelectric film that allows the piezoelectric properties of the piezoelectric film to be exhibited sufficiently. When the thickness of the thermosetting hard coat layer is in the above-described range, both sufficient piezoelectricity and transparency suited to the application of the piezoelectric film can be easily achieved in the multilayer piezoelectric film.

Ultraviolet-Curable Hard Coat Layer

In a multilayer piezoelectric film according to another embodiment of the present invention, in the above-described multilayer piezoelectric film, a thermosetting hard coat layer is laminated on one surface of the piezoelectric film, and an ultraviolet-curable hard coat layer is further laminated on the other surface thereof. As a result, the hard coat layers on both surfaces of the piezoelectric film cover the fine irregularities on the surface of the piezoelectric film, and the haze can be further reduced. In addition, since the hard coat layer suppresses thermal shrinkage, dimensional stability is enhanced.

The ultraviolet-curable hard coat layer is a layer of an ultraviolet-curable resin. Examples of the ultraviolet-curable resin include various resins such as polyester resins, (meth)acrylic resins, urethane resins, amide resins, silicone resins, and epoxy resins, and include ultraviolet-curable monomers, oligomers, and polymers. In addition, an ultraviolet polymerization initiator is blended in the ultraviolet-curable resin. In particular, (meth)acrylic resins are preferable from the viewpoints of sufficient transparency, abundance of material types, and reduction of raw material price.

The thickness of the ultraviolet-curable hard coat layer is preferably 0.3 $\mu$m or more, and more preferably 0.5 $\mu$m or more, from the viewpoint of scratch resistance or transparency. In addition, the thickness of the ultraviolet-curable hard coat layer is preferably 5 $\mu$m or less, more preferably 3 $\mu$m or less, and even more preferably 2 $\mu$m or less, from the viewpoint of piezoelectric properties. When the thickness of the ultraviolet-curable hard coat layer is within the above-described range, sufficient scratch resistance is obtained while haze is reduced, and high piezoelectric properties are exhibited.

Suitable embodiments of the present invention have been described above-described, but the present invention is not limited to the embodiments described above-described. In the multilayer piezoelectric film 1, an optional layer may be provided at any position in addition to the layers described above-described to the extent that its function is not significantly impaired.

Application of Multilayer Piezoelectric Film

The multilayer piezoelectric film according to the present invention is suitably used for devices such as a piezoelectric panel including a touch panel of an electrostatic capacitance type, a resistive film type, or the like, a pressure sensor, an actuator for a haptic device, a piezoelectric vibration power generator, and a planar speaker.

The piezoelectric panel further includes a general display panel unit such as a liquid crystal display (LCD) under the multilayer piezoelectric film.

The above-described device is suitably used in mobile phones, smartphones, personal digital assistants, tablet PCs, notebook personal computers, FA equipment, OA equipment, medical devices, car navigation systems, and the like.

Method for Producing Multilayer Piezoelectric Film

The multilayer piezoelectric film according to the present invention relates to a method for producing the multilayer piezoelectric film, the method including: applying a thermosetting hard coating agent to at least one surface having a water contact angle of 75° or less of a piezoelectric film having an absolute value of a thermal shrinkage rate of 2.0% or more in at least either a machine direction (MD) or a transverse direction (TD) (application step A); and heat-treating the applied piezoelectric film at 110°C or more and 140°C or less for 15 seconds or more and 80 minutes or less (heat treatment step A).

As described above-described, in the piezoelectric film, the hard coat layer is laminated in order to improve the scratch resistance. In addition, in order to prevent an appearance defect due to the thermal shrinkage, a preheating treatment for heating the piezoelectric film is performed before the treatment involving heating. However, this leads to an increase in cost, which is particularly problematic in a piezoelectric film in which material cost and processing cost are high.

In view of such an issue, the present inventors have conducted studies for forming a hard coat layer on the piezoelectric film without preheating the piezoelectric film, and resultantly found that by applying a thermosetting hard coating agent to a surface of the piezoelectric film having a water contact angle of 75° or less and performing heat treatment at a predetermined temperature and for a predetermined time, a hard coat layer forming treatment can be performed without preheating, and a multilayer piezoelectric film excellent in thermal stability, adhesiveness, and transparency can be provided at low cost.

Application Step A

The surface of the piezoelectric film to which the thermosetting hard coating agent is applied has a water contact angle of 75° or less. By forming a thermosetting hard coat layer on the surface of such a piezoelectric film, the adhesiveness between the thermosetting hard coat layer and the piezoelectric film can be improved.

In the present specification, the water contact angle is a value obtained in the following operation using a contact angle meter FACE CA-V (manufactured by Kyowa Interface Science Co., Ltd.): dropping a pure water droplet (2.0 μL) on a surface, measuring the contact angle 10 times 3 seconds after the dropping, and arithmetically averaging the measured contact angles.

Examples of a method for setting the water contact angle to 75 ° or less include a method in which a surface modification treatment such as a corona treatment, a plasma treatment, a flame treatment, or an ultraviolet irradiation treatment is performed on the surface of the piezoelectric film to which the thermosetting hard coating agent is applied. Among them, the corona treatment is preferable because good adhesiveness is likely to be obtained.

Examples of the thermosetting hard coating agent include the thermosetting resin compositions described above-described.

The method of applying the thermosetting hard coating agent is not particularly limited, and may be performed by a known method. Examples of the application method include an extrusion nozzle method, a blade method, a knife method, a bar-coating method, a kiss-coating method, a kiss reverse method, a gravure roll method, a dip method, a reverse roll method, a direct roll method, a curtain method, and a squeeze method.

Heat Treatment Step A

After the application step A, a heat treatment step A of heat-treating the applied piezoelectric film at 110°C. or more and 140°C. or less for 15 seconds or more and 80 minutes or less is performed. As a result, the thermosetting hard coat layer can be formed without preheating the piezoelectric film.

The heat treat temperature for the applied piezoelectric film is preferably 110°C or higher and 140°C or lower, and more preferably 120°C or higher and 130°C or lower. The heat treatment time is preferably 15 seconds or more and 80 minutes or less, and more preferably 1 minute or more and 40 minutes or less. When the heat treatment temperature and the heat treatment time exceed the lower limits, good thermal stability is likely to be obtained. In addition, when the heat treatment time and the heat treatment time are equal to or less than the upper limits, deterioration of the piezoelectric film is unlikely to occur. Therefore, optical properties such as a haze value, total light transmittance, and b*, and piezoelectricity are less likely to deteriorate.

Ultraviolet-Curable Hard Coat Layer Forming Step

After the heat treatment step A, a step for forming an ultraviolet-curable hard coat layer can be optionally carried out. In the ultraviolet-curable hard coat layer forming step, an ultraviolet-curable hard coating agent is applied to the piezoelectric film having surfaces on one of which the thermosetting hard coat layer is formed, wherein the ultraviolet-curable hard coating agent is applied on the other surface on which the thermosetting hard coat layer is not formed (application step B). The applied piezoelectric film is heat-treated (heat treatment step B), and then irradiated with ultraviolet rays (ultraviolet-curing step).

In the application step B, the surface of the piezoelectric film to which the ultraviolet-curable hard coating agent is applied may be subjected to the same treatment as that for the thermosetting hard coating agent-applied surface. Examples of the ultraviolet-curable hard coating agent include the above-described acrylic resins. As the coating method, the same as that described for the thermosetting hard coating agent can be used. The coating method may be the same as or different from the method for coating the thermosetting hard coating agent.

Next, in the heat treatment step B, the piezoelectric film to which the ultraviolet-curable hard coating agent is applied is heat-treated. The temperature at this time is preferably lower than the temperature of the above-described heat treatment step A from the viewpoint that deterioration of the piezoelectric film hardly occurs. Specifically, the temperature is preferably 40°C or more and 100°C or less. The heat treatment time is preferably 1 minute or more and 60 minutes or less.

Thereafter, in the ultraviolet-curing step, the applied surface is irradiated with ultraviolet rays to form an ultraviolet-curable hard coat layer. The irradiation amount of ultraviolet rays is preferably, for example, from 100 mJ/cm$^2$ to 800 mJ/cm$^2$ in terms of cumulative light amount, although it depends on the coating thickness of the ultraviolet-curable hard coating agent. The intensity of the ultraviolet ray is not particularly limited, but is preferably 200 mW/cm$^2$ or more and 500 mW/cm$^2$ or less from the viewpoint of scratch resistance of the hard coat layer.

## EXAMPLES

The present invention will be further described with reference to examples and comparative examples below, but the present invention is not limited to these examples.

The properties of the multilayer piezoelectric film according to an embodiment of the present invention were measured by the following methods, and the results are indicated in Table 1.

Thickness of Thermosetting Hard Coat Layer

Each of the multilayer piezoelectric films of Examples and Comparative Examples was embedded in an epoxy resin, and the epoxy resin mass was cut so that a cross section of the multilayer piezoelectric film was exposed. The exposed cross-section of the multilayer piezoelectric film was observed using a scanning electron microscope ("SU3800", available from Hitachi High-Technologies Corporation) under the conditions of an acceleration voltage of 3.0 kV and a magnification of 50000 times to measure the thickness of the thermosetting hard coat layer in the multilayer piezoelectric film.

The thickness was measured at two points, and the arithmetic mean value thereof was defined as the thickness of each thermosetting hard coat layer. Under the above-described observation conditions, each interface of the thermosetting hard coat layers was observed as a substantially smooth line, and in the measurement of the thickness, the distance between the interface lines was measured.

Thermal Shrinkage Rate

In a test method in accordance with JIS K 7133, the multilayer piezoelectric film was cut into a size of 120 mm × 120 mm, and distances between two gauge lines (L0 and T0) before the test, which were marked in a machine direction and a transverse direction on the cut test piece, was measured. The flow direction of the film during application of the hard coating agent was defined as the machine direction, and the direction perpendicular thereto was defined as the transverse direction.

Next, after heating for a predetermined time (30 minutes) in a hot air drying oven heated to a predetermined temperature (100°C), the condition is adjusted at room temperature for at least 30 minutes, and the distances (L and T) between the gauge lines in the machine direction and between those in the transverse direction were measured again, and changes (ΔL and ΔT) in the distances between the gauge lines in the machine direction and the transverse direction were calculated for the test piece using the following formulas (1) and (2).

$$\Delta L = [(L-L0)/L0] \times 100 \ (\%) \quad (1)$$

$$\Delta T = [(T-T0)/T0] \times 100 \ (\%) \quad (2)$$

Then, the change ($\Delta L$) in the distance between the gauge lines in the above-described machine direction was defined as the thermal shrinkage rate of the film in the machine direction, and the change ($\Delta T$) in the distance between the gauge lines in the above-described transverse direction was defined as the thermal shrinkage rate of the film in the transverse direction. In the table, "MD" represents the thermal shrinkage rate in the machine direction, and "TD" represents the thermal shrinkage rate in the transverse direction.

Adhesiveness

The adhesiveness of each multilayer piezoelectric film was evaluated using a cross-cut method. In the thermosetting hard coat layer of each multilayer piezoelectric film, 11 vertical lines and 11 horizontal lines at 1-mm intervals were drawn with a utility knife to prepare 100 squares. Then, a tape (Cellotape (trade name) available from Nichiban Co., Ltd., adhesive strength 4.01 N/10 mm) was applied and peeled off, and a proportion of the thermosetting hard coat layer that peeled off from the multilayer piezoelectric film was evaluated in accordance with the following evaluation criteria based on ASTM D3359.

0B: 65% or more peeled off
1B: 35% or more and less than 65% peeled off
2B: 15% or more and less than 35% peeled off
3B: 5% or more and less than 15% peeled off
4B: less than 5% peeled off
5B: no peeling off

Haze Value

The haze value of each of the multilayer piezoelectric films used in Examples and Comparative Examples was measured using a haze meter ("NDH7000SP II", available from Nippon Denshoku Industries Co., Ltd.) based on the method described in JIS K 7136.

Total Light Transmittance

The total light transmittance of each of the multilayer piezoelectric films used in Examples and Comparative Examples was measured using a haze meter ("NDH7000SP II", available from Nippon Denshoku Industries Co., Ltd.) based on the method described in JIS K 7361-1.

b* Value

The b* value in the L*a*b* color system of each of the multilayer piezoelectric films used in Examples and Comparative Examples were measured using a spectrocolorimeter ("SD7000", available from Nippon Denshoku Industries Co., Ltd.) in accordance with the method described in JIS K 8722.

Piezoelectric Constant $d_{33}$ Value

The piezoelectric constant $d_{33}$ of each of the multilayer piezoelectric films used in Examples and Comparative Examples was measured by using a piezoelectric constant measuring device ("Piezometer System PM300", available from Piezotest Pte Ltd) by clipping a sample at 0.2 N and reading the generated charge when a force of 0.15 N and 110 Hz was applied. The actual measurement value of the piezoelectric constant $d_{33}$ is a positive value or a negative value, depending on whether the front or back side of the film is measured; however, the absolute value is used in the present specification.

Example 1

A resin film (120 $\mu$m in thickness) formed from polyvinylidene fluoride (available from Kureha Corporation) with an inherent viscosity of 1.1 dl/g was uniaxially stretched at a stretching ratio of 4.2 times. After stretching, the film was subjected to a polarization process by applying a DC voltage between the ground electrode and the needle-shaped electrode while increasing the DC voltage from 0 kV to 12.0 kV, thereby obtaining a piezoelectric film. When this piezoelectric film was heat-treated at 100°C for 30 minutes, the thermal shrinkage rate was -5.3% in the machine direction (MD) and 1.5% in the transverse direction (TD). In addition, the piezoelectric constant $d_{33}$ of the piezoelectric film was 16.0 pC/N, and the water contact angle of the surface was 80°.

Corona treatment was performed on one surface of the piezoelectric film until the water contact angle reached 70 °.

A heat-curable hard coating agent prepared by mixing 10 parts by mass of acrylate DA105 (manufactured by Arakawa Chemical Industries, Ltd.) and 4 parts by mass of isocyanate CL102H (manufactured by Arakawa Chemical Industries, Ltd.) as a curing agent and the thermosetting hard coating agent diluting the mixture with methylethylketone (MEK) was applied to the surface of the piezoelectric film subjected to the corona treatment, and heat treatment was performed at 130°C for 40 seconds while fixing the film end portion in the TD direction. Thereby multilayer piezoelectric films including thermosetting hard coat layers having respective thicknesses indicated in Table 1 were obtained.

Examples 2, 3, and 4

Multilayer piezoelectric films were obtained in the same manner as in Example 1 except that the heat treatment time was changed to the time indicated in Table 1.

Example 5

A multilayer piezoelectric film having a 1.0 $\mu$m-thick ultraviolet-curable hard coat layer was obtained by applying an ultraviolet-curable hard coating agent BS CH271 (manufactured by Arakawa Chemical Industries, Ltd.) to the surface of the piezoelectric film on the side opposite the thermosetting hard coat layer of the multilayer piezoelectric film obtained in Example 1, heat-treated at 80°C for 2 minutes, and irradiated with ultraviolet rays at an integrated light amount of 400 mJ/cm$^2$.

Example 6

A multilayer piezoelectric film was obtained in the same manner as in Example 5 except that the heat treatment temperature was changed to the temperature indicated in Table 1.

Example 7

A multilayer piezoelectric film was obtained in the same manner as in Example 5 except that the heat treatment temperature and time were changed to the temperature and time indicated in Table 1.

Comparative Examples 1 and 2

Multilayer piezoelectric films were obtained in the same manner as in Example 1 except that the heat treatment time was changed to the time indicated in Table 1. The multilayer piezoelectric film of Comparative Example 2 could not be evaluated for the thermal shrinkage rate and the piezoelectric constant $d_{33}$ due to defects of the appearance of the film such as wrinkles.

Comparative Examples 3 and 4

Multilayer piezoelectric films were obtained in the same manner as in Example 1 except that the heat treatment temperature and time were changed to the temperature and time indicated in Table 1. The multilayer piezoelectric film of Comparative Example 3 could not be evaluated for the thermal shrinkage rate and the piezoelectric constant $d_{33}$ due to defects of the appearance of the film such as wrinkles.

Comparative Example 5

A multilayer piezoelectric film was obtained in the same manner as in Example 1 except that the piezoelectric film was not subjected to the corona treatment.

Comparative Example 6

A multilayer piezoelectric film was obtained in the same manner as in Example 2 except that the acrylic thermosetting hard coating agent was changed to an amorphous silica-containing ultraviolet-curable resin composition, and UV irradiation was performed at an integrated light amount of 400 mJ/cm$^2$ using a UV irradiation CSOT-40 (manufactured by GS Yuasa Corporation) after the heat treatment. Since the hard coat layer of the obtained multilayer piezoelectric film was uncured, the thermal shrinkage rate and the optical properties (haze value, total light transmittance, b* value) were not measured.

[Table 1]

| | (°) | (°C) | Temperature | Time (μm) | Coat layer thickness MD (%) | Thermal shrinkage rate TD (%) | Adhesiveness | Haze value (%) | Total light transmittance (%) | b* | $d_{33}$ (pC/N) |
|---|---|---|---|---|---|---|---|---|---|---|---|
| | | | | | | | | | | | |
| Example 1 | 70 | 130 | 40 sec | 1.0 | -0.76 | 0.23 | 5B | 1.3 | 92.4 | 0.2 | 15.1 |
| Example 2 | 70 | 130 | 15 min | 1.0 | -0.29 | 0.12 | 5B | 1.4 | 92.0 | 0.3 | 13.6 |
| Example 3 | 70 | 130 | 30 min | 1.0 | -0.06 | 0.10 | 5B | 1.4 | 91.8 | 0.3 | 12.3 |
| Example 4 | 70 | 130 | 60 min | 1.0 | -0.40 | 0.15 | 5B | 1.4 | 91.6 | 0.4 | 12.1 |
| Example 5 | 70 | 130 | 40 sec | 1.0 | -0.40 | 0.08 | 5B | 0.3 | 91.9 | 0.1 | 15.0 |
| Example 6 | 70 | 140 | 40 sec | 1.0 | -0.26 | 0.06 | 5B | 0.3 | 91.7 | 0.1 | 14.8 |
| Example 7 | 70 | 120 | 2 min | 1.0 | -0.45 | 0.12 | 5B | 0.3 | 91.9 | 0.2 | 16.0 |
| Comparative Example 1 | 70 | 130 | 10 sec | 1.0 | 4.9 | 1.2 | 5B | 1.8 | 93.3 | 0.2 | 16.0 |
| Comparative Example 2 | 70 | 130 | 180 min | 1.0 | - | - | 5B | 1.5 | 90.8 | 0.8 | - |
| Comparative Example 3 | 70 | 160 | 60 min | 1.0 | - | - | 5B | 4.9 | 88.9 | 3.3 | - |
| Comparative Example 4 | 70 | 100 | 2 min | 1.0 | 2.6 | 0.7 | 5B | 1.6 | 93.9 | 0.1 | 16.5 |
| Comparative Example 5 | 80 | 130 | 40 sec | 1.0 | -0.76 | 0.23 | 3B | 2.0 | 91.5 | 0.1 | 14.2 |
| Comparative Example 6 | 70 | 130 | 40 sec | 1.0 | - | - | 0B | - | - | - | 14.5 |

As indicated in Table 1, Examples exhibited a low thermal shrinkage rate, good adhesiveness, and high brightness. Therefore, it was confirmed that a multilayer piezoelectric film having excellent thermal stability, adhesiveness, and transparency can be obtained by the present invention.

**REFERENCE SIGNS LIST**

1: Multilayer piezoelectric film, 11: Piezoelectric film, 21: Thermosetting hard coat layer

**Claims**

1. A multilayer piezoelectric film comprising:

   a piezoelectric film comprising a fluorine-based resin as a main component; and
   a thermosetting hard coat layer laminated on at least one surface of the piezoelectric film,
   wherein the multilayer piezoelectric film has an absolute value of a thermal shrinkage rate of 1.0% or less in both a machine direction (MD) and a transverse direction (TD) when heat-treated at 100°C for 30 minutes,
   adhesiveness between the piezoelectric film and the thermosetting hard coat layer as evaluated based on ASTM D3359 is 4B or more, and
   b* in an L*a*b* color system is -0.7 or more and 0.7 or less.

2. The multilayer piezoelectric film according to claim 1, comprising an ultraviolet-curable hard coat layer on a surface of the piezoelectric film on the side opposite the thermosetting hard coat layer.

3. The multilayer piezoelectric film according to claim 1 or 2,
   wherein the multilayer piezoelectric film has a piezoelectric constant $d_{33}$ of 10 pC/N or greater.

4. The multilayer piezoelectric film according to claim 1 or 2,
   wherein the multilayer piezoelectric film has a total light transmittance of 90% or more.

5. The multilayer piezoelectric film according to claim 1 or 2,
   wherein the thermosetting hard coat layer contains at least one selected from the group consisting of an (meth)acrylic resin, an epoxy resin, an amino resin, and a urethane resin.

6. A device comprising the multilayer piezoelectric film described in claim 1 or 2.

7. A method for producing a multilayer piezoelectric film, the method comprising:

   applying a thermosetting hard coating agent to at least one surface having a water contact angle of 75° or less of a piezoelectric film having an absolute value of a thermal shrinkage rate of 2.0% or more in at least either a machine direction (MD) or a transverse direction (TD); and
   heat-treating the applied piezoelectric film at 110°C or more and 140°C or less for 15 seconds or more and 80 minutes or less.

8. The method for producing a multilayer piezoelectric film according to claim 7,
   the method comprising:

   applying an ultraviolet-curable hard coating agent to a surface of the piezoelectric film on the side opposite the thermosetting hard coat layer;
   heat-treating the applied piezoelectric film at 40°C or more and 100°C or less; and
   irradiating the ultraviolet-curable hard coating agent-applied surface with ultraviolet rays.

9. The method for producing a multilayer piezoelectric film according to claim 7 or 8,
   wherein a method for adjusting the water contact angle to 75° or less is corona treatment.

FIG. 1

1

21

11

## INTERNATIONAL SEARCH REPORT

| International application No. |
| --- |
| **PCT/JP2023/017501** |

**A.    CLASSIFICATION OF SUBJECT MATTER**

**B05D 3/00**(2006.01)i; **B05D 3/02**(2006.01)i; **B05D 7/00**(2006.01)i; **B32B 27/30**(2006.01)i; **C08J 7/046**(2020.01)i; **H10N 30/20**(2023.01)i; **H10N 30/30**(2023.01)i; **H10N 30/85**(2023.01)i; **H10N 30/857**(2023.01)i
FI:    H10N30/857; B32B27/30 D; H10N30/20; H10N30/30; H10N30/85; B05D7/00 K; B05D3/02 Z; B05D3/00 D; B05D7/00 A; C08J7/046 CEW

According to International Patent Classification (IPC) or to both national classification and IPC

**B.    FIELDS SEARCHED**

Minimum documentation searched (classification system followed by classification symbols)

B05D3/00; B05D3/02; B05D7/00; B32B27/30; C08J7/046; H10N30/20; H10N30/30; H10N30/85; H10N30/857

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
| --- | --- | --- |
| A | WO 2022/091829 A1 (KUREHA CORPORATION) 05 May 2022 (2022-05-05) paragraphs [0012]-[0112], fig. 1-4 | 1-9 |
| A | WO 2017/209080 A1 (NITTO DENKO CORP) 07 December 2017 (2017-12-07) paragraphs [0029]-[0090], fig. 1-10 | 1-9 |
| A | JP 2007-134293 A (HS PLANNING KK) 31 May 2007 (2007-05-31) paragraphs [0013]-[0073], fig. 1 | 1-9 |
| A | JP 2019-066630 A (HITACHI CHEMICAL CO LTD) 25 April 2019 (2019-04-25) paragraphs [0030]-[0164], fig. 1-3 | 1-9 |
| A | JP 2021-075012 A (KONICA MINOLTA INC) 20 May 2021 (2021-05-20) paragraphs [0014]-[0180], fig. 1 | 1-9 |

☐ Further documents are listed in the continuation of Box C.    ☑ See patent family annex.

| | |
| --- | --- |
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| **26 July 2023** | **08 August 2023** |

| Name and mailing address of the ISA/JP | Authorized officer |
| --- | --- |
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
**Information on patent family members**

International application No.

**PCT/JP2023/017501**

| Patent document cited in search report | | | Publication date (day/month/year) | Patent family member(s) | | | Publication date (day/month/year) |
|---|---|---|---|---|---|---|---|
| WO | 2022/091829 | A1 | 05 May 2022 | TW | 202217862 | A | |
| WO | 2017/209080 | A1 | 07 December 2017 | CN | 109196673 | A | |
| | | | | KR | 10-2019-0015188 | A | |
| | | | | TW | 201743176 | A | |
| JP | 2007-134293 | A | 31 May 2007 | (Family: none) | | | |
| JP | 2019-066630 | A | 25 April 2019 | (Family: none) | | | |
| JP | 2021-075012 | A | 20 May 2021 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H05324203 A